# EUROPEAN PATENT APPLICATION

(11) **EP 4 585 577 A1**
(43) Date of publication of application: **16.07.2025**
(21) Application number: 23876805.5
(22) Date of filing: 13.10.2023
(51) Int. Cl.: C03C 17/34, C03C 27/10, B60J 1/02, B60J 1/00, B60R 11/02, G02B 27/01

(54) **VEHICLE WINDOW GLASS AND PREPARATION METHOD THEREFOR, AND VEHICLE**

(30) Priority: 14.10.2022 CN 202211256674
(71) Applicant: Fuyao Glass Industry Group Co., Ltd., Fuqing, Fujian 350300 (CN)
(72) Inventor: TSO, Fai, Fuqing Fujian 350300 (CN); ZHANG, Jielin, Fuqing Fujian 350300 (CN); ZHANG, Canzhong, Fuqing Fujian 350300 (CN); LU, Guoshui, Fuqing Fujian 350300 (CN); ZHU, Rui, Fuqing Fujian 350300 (CN); FUKUHARA, Kohta, Fuqing Fujian 350300 (CN)
(74) Representative: Mewburn Ellis LLP
(86) International application number: PCT/CN2023/124434
(87) International publication number: WO 2024/078606

(57) **Abstract**

Vehicle window glass (100) is provided. The vehicle window glass (100) includes a glass substrate (210) and a transparent nano coating (220). The glass substrate (210) has an outer surface (210b) and an inner surface (210a) opposite to the outer surface (210b). The transparent nano coating (220) is disposed on the inner surface (210a). The transparent nano coating (220) includes an enhanced high refractive-index layer (221) and an outermost low refractive-index layer (222). The enhanced high refractive-index layer (221) and the outermost low refractive-index layer (222) are sequentially laminated in a direction away from the inner surface (210a). The enhanced high refractive-index layer (221) has a refractive index greater than or equal to 2.6. The outermost low refractive-index layer (222) has a refractive index ranging from 1.35 to 1.60.

## Description

This application claims priority to Chinese Patent Application No. 202211256674.9, filed October 14, 2022, and entitled "VEHICLE WINDOW GLASS AND MANUFACTURING METHOD THEREFOR, AND VEHICLE", the entire disclosure of which is hereby incorporated by reference.

### TECHNICAL FIELD

This disclosure relates to the field of glass technology, and in particular to vehicle window glass and a manufacturing method therefor, and vehicle.

### BACKGROUND

With the development of vehicle intelligence, head-up display (HUD) systems are increasingly applied to vehicles. The head-up display system can display important driving information, such as speed, engine revolutions per minute (rpm), fuel consumption, tire pressure, navigation, and information about an external smart device, in field of view of a driver in real time, so that the driver can see the information on a dashboard and other devices without looking down, thereby avoiding distracting the driver from the road ahead. In addition, the driver does not need to adjust eyes between observing a long-range road and a short-range dashboard, which can avoid eye fatigue and can greatly enhance driving safety and improve driving experience.

Meanwhile, in recent years, with the explosive demand for autonomous driving, LiDAR has been increasingly applied to vehicles. If the LiDAR is installed on a roof or other exterior parts of the vehicle, the LiDAR needs to face the impact of various climate conditions and vehicle vibrations during driving, which can challenge the stability and precision of the LiDAR. As a result, more and more solutions involve installing the LiDAR inside the vehicle. In this case, detection light of the LiDAR needs to pass through the vehicle window glass. However, conventional vehicle window glass, designed to meet a heat insulation requirement, has a low infrared transmittance, so that it is difficult for existing vehicle window glass to meet the high-precision detection requirement for the LiDAR.

In order for a head-up display image to be displayed sharply without ghosting, the vehicle window glass needs to have a high reflectivity for projection light. At present, it is difficult for the existing vehicle window glass to meet both the high transmittance requirement for LiDAR signals and high reflectivity requirement for the head-up display system.

### SUMMARY

Embodiments of the present disclosure provide vehicle window glass, a manufacturing method therefor, and a vehicle, which can meet both the high transmittance requirement for LiDAR signals and high reflectivity requirement for a head-up display system.

In a first aspect, vehicle window glass is provided in the present disclosure. The vehicle window glass includes a glass substrate and a transparent nano coating. The glass substrate has an outer surface and an inner surface opposite to the outer surface. The transparent nano coating is disposed on the inner surface. The transparent nano coating includes an enhanced high refractive-index layer and an outermost low refractive-index layer. The enhanced high refractive-index layer and the outermost low refractive-index layer are sequentially laminated in a direction away from the inner surface. The enhanced high refractive-index layer has a refractive index greater than or equal to 2.6. The outermost low refractive-index layer has a refractive index ranging from 1.35 to 1.60.

It can be understood that when the refractive index of the enhanced high refractive-index layer is greater than or equal to 2.6, the vehicle window glass provided with the transparent nano coating can have the high transmittance for the LiDAR signal, and the surface of the vehicle window glass facing the inside of the vehicle also has the high reflectivity for the projection light of the head-up display system. The LiDAR and the head-up display system can both be integrated and used together with the vehicle window glass, so that the vehicle can better assist the driver.

In a possible implementation, the vehicle window glass has a transmittance greater than or equal to 80% for P-polarized light having a wavelength ranging from 850 nm to 1650 nm incident at an incident angle ranging from 50° to 73°.

In a possible implementation, the vehicle window glass has a reflectivity greater than or equal to 20% for P-polarized light having a wavelength of 380 nm to 780 nm incident from an inside of a vehicle at an incident angle ranging from 45° to 85°.

In a possible implementation, the enhanced high refractive-index layer has a thickness ranging from 35 nm to 70 nm.

In a possible implementation, the outermost low refractive-index layer has a thickness ranging from 75 nm to 130 nm.

In a possible implementation, the enhanced high refractive-index layer is a TiOₓ layer. A proportion of rutile-structured TiOₓ in the TiOₓ layer is at least 90%.

In a possible implementation, the TiOₓ layer has a refractive index n ranging from 2.60 to 2.72, and has an extinction coefficient k greater than or equal to 0.0015.

In a possible implementation, the glass substrate includes outer glass, inner glass, and an intermediate layer disposed between the outer glass and the inner glass. A surface of the outer glass away from the intermediate layer is the outer surface. A surface of the inner glass away from the intermediate layer is the inner surface. The outer glass and/or the inner glass has a transmittance greater than or equal to 91% for near-infrared light having a wavelength ranging from 850 nm to 1650 nm.

In a possible implementation, the transparent nano coating is composed of the enhanced high refractive-index layer and the outermost low refractive-index layer. The enhanced high refractive-index layer has a thickness ranging from 45 nm to 65 nm. The outermost low refractive-index layer has a thickness ranging from 90 nm to 120 nm.

In a possible implementation, the transparent nano coating further includes at least one laminated structure. At least one laminated structure is disposed between the enhanced high refractive-index layer and the inner glass. Each of the at least one laminated structure includes a high refractive-index layer and a low refractive-index layer that are sequentially laminated. The high refractive-index layer has a refractive index ranging from 1.61 to 2.59. The low refractive-index layer has a refractive index ranging from 1.35 to 1.60.

In a possible implementation, the at least one laminated structure is implemented as one laminated structure. The high refractive-index layer is disposed on a surface of the inner glass away from the intermediate layer. The low refractive-index layer is disposed between the high refractive-index layer and the enhanced high refractive-index layer. The high refractive-index layer has a thickness ranging from 2 nm to 190 nm. The low refractive-index layer has a thickness ranging from 5 nm to 95 nm. The enhanced high refractive-index layer has a thickness ranging from 45 nm to 65 nm. The outermost low refractive-index layer has a thickness ranging from 85 nm to 130 nm.

In a possible implementation, the at least one laminated structure is implemented as two laminated structures. The two laminated structures include a first laminated structure and a second laminated structure. The first laminated structure includes a first high refractive-index layer and a first low refractive-index layer. The second laminated structure includes a second high refractive-index layer and a second low refractive-index layer. The first high refractive-index layer, the first low refractive-index layer, the second high refractive-index layer, the second low refractive-index layer, the enhanced high refractive-index layer, and the outermost low refractive-index layer are sequentially laminated on the surface of the inner glass away from the intermediate layer. The first high refractive-index layer has a thickness ranging from 140 nm to 190 nm. The first low refractive-index layer has a thickness ranging from 5 nm to 95 nm. The second high refractive-index layer has a thickness ranging from 130 nm to 205 nm. The second low refractive-index layer has a thickness ranging from 25 nm to 90 nm. The enhanced high refractive-index layer has a thickness ranging from 45 nm to 65 nm. The outermost low refractive-index layer has a thickness ranging from 75 nm to 105 nm.

In a possible implementation, the intermediate layer has a wedge angle equal to 0, or ranging from 0.01 mrad to 0.15 mrad.

In a possible implementation, the intermediate layer is a tinted intermediate layer having a visible light transmittance greater than or equal to 80%.

In a possible implementation, the vehicle window glass has a visible light transmittance greater than or equal to 70%. A reflected color of the vehicle window glass measured from the outer surface has a value of *a* less than 3 and a value of *b* less than 0.5 in a color space Lab.

In a possible implementation, a range of reflectivities of the vehicle window glass for P-polarized light having wavelengths of 469 nm, 529 nm, and 629 nm, incident from an inside of a vehicle at an incident angle of 65°, is less than or equal to 3%.

In a second aspect, a vehicle is provided in the present disclosure. The vehicle includes a detection assembly, a projection assembly, and the vehicle window glass as described above. The detection assembly and the projection assembly are disposed at one side of the vehicle window glass where the transparent nano coating is disposed. The vehicle window glass has a signal transmission region and/or a head-up display region. The detection assembly is configured to emit and/or receive detection light having a wavelength ranging from 850 nm to 1650 nm. The detection light is configured to pass through the vehicle window glass. The projection assembly is configured to emit projection light having a wavelength ranging from 380 nm to 780 nm towards the head-up display region. The detection light is incident onto the signal transmission region at an incident angle ranging from 50° to 73°. At least 80% of the detection light is P-polarized light. The projection light is incident onto the head-up display region at an incident angle ranging from 45° to 85°. At least 90% of the projection light is P-polarized light.

In a third aspect, a manufacturing method for vehicle window glass is provided. The manufacturing method includes the following. Inner glass is provided. A transparent nano coating is formed on a surface of the inner glass. The transparent nano coating includes an enhanced high refractive-index layer and an outermost low refractive-index layer. The enhanced high refractive-index layer and the outermost low refractive-index layer are sequentially laminated in a direction away from the inner glass. The enhanced high refractive-index layer has a refractive index greater than or equal to 2.6. The outermost low refractive-index layer has a refractive index ranging from 1.35 to 1.60. The vehicle window glass is formed by laminating outer glass, an intermediate layer, and the inner glass provided with the transparent nano coating.

In a possible implementation, forming the transparent nano coating on the surface of the inner glass includes the following. The enhanced high refractive-index layer is formed by magnetron sputtering. A target power supply for magnetron sputtering of the enhanced high refractive-index layer is a high-power impulse magnetron sputtering (HiPIMS) power supply. The outermost low refractive-index layer is formed on a surface of the enhanced high refractive-index layer away from the inner glass by magnetron sputtering. A target power supply for magnetron sputtering of the outermost low refractive-index layer is a mid-range frequency (MF) magnetron sputtering power supply.

In a possible implementation, the transparent nano coating further includes at least one laminated structure. The at least one laminated structure is disposed between the enhanced high refractive-index layer and the inner glass. Each of the at least one laminated structure includes a high refractive-index layer and a low refractive-index layer that are sequentially laminated. The high refractive-index layer has a refractive index ranging from 1.61 to 2.59. The low refractive-index layer has a refractive index ranging from 1.35 to 1.60. The high refractive-index layer and the low refractive-index layer are formed by magnetron sputtering. A target power supply for magnetron sputtering of the high refractive-index layer and the low refractive-index layer is a MF magnetron sputtering power supply.

### BRIEF DESCRIPTION OF THE DRAWINGS

To describe the technical solutions in the present disclosure more clearly, the accompanying drawings for use in implementations are briefly described below. Apparently, the accompanying drawings in the following description show merely some implementations of the present disclosure, and those of ordinary skill in the art may obtain other accompanying drawings from these accompanying drawings without creative effort.
FIG. 1 is a schematic structural view of a vehicle provided in an embodiment of the present disclosure.
FIG. 2 is a schematic top view of the vehicle window glass illustrated in FIG. 1.
FIG. 3 is a schematic structural view of the vehicle window glass illustrated in FIG. 1.
FIG. 4 is a schematic structural view of a glass substrate illustrated in FIG. 3 being laminated glass.
FIG. 5 is a schematic structural view of vehicle window glass illustrated in FIG. 4 in a first possible implementation.
FIG. 6 is a schematic structural view of vehicle window glass illustrated in FIG. 4 in a second possible implementation.
FIG. 7 is a schematic structural view of vehicle window glass illustrated in FIG. 4 in a third possible implementation.
FIG. 8 is a graph of a spectral reflectivity of the vehicle window glass, provided in example 6, for P-polarized light having a wavelength of 400 nm to 1600 nm incident at an incident angle of 65°.
FIG. 9 is a flow chart of a manufacturing method for vehicle window glass provided in an embodiment of the present disclosure.

### DETAILED DESCRIPTION

For the convenience of understanding, first, the terms involved in embodiments of the present disclosure are explained.

Refractive index: a refractive index of transmitted light having a wavelength of 550 nm. A refractive index of each transparent nano coating is measured after the transparent nano coating is subjected to a high-temperature heat treatment of at least 560°C and a bending treatment.

Thickness: physical thickness.

Extinction coefficient: the light absorption characteristics of the medium, indicating the degree of intensity reduction when light passes through a material.

Incident angle: an angle between detection light or projection light incident onto vehicle window glass and a normal line at an incident position.

In the following, specific implementations of the present disclosure will be clearly described with reference to the accompanying drawings.

Embodiments of the present disclosure provide vehicle window glass and a vehicle, which can meet both the high transmittance requirement for the detection light of the detection assembly and high reflectivity requirement for the projection light of the projection assembly.

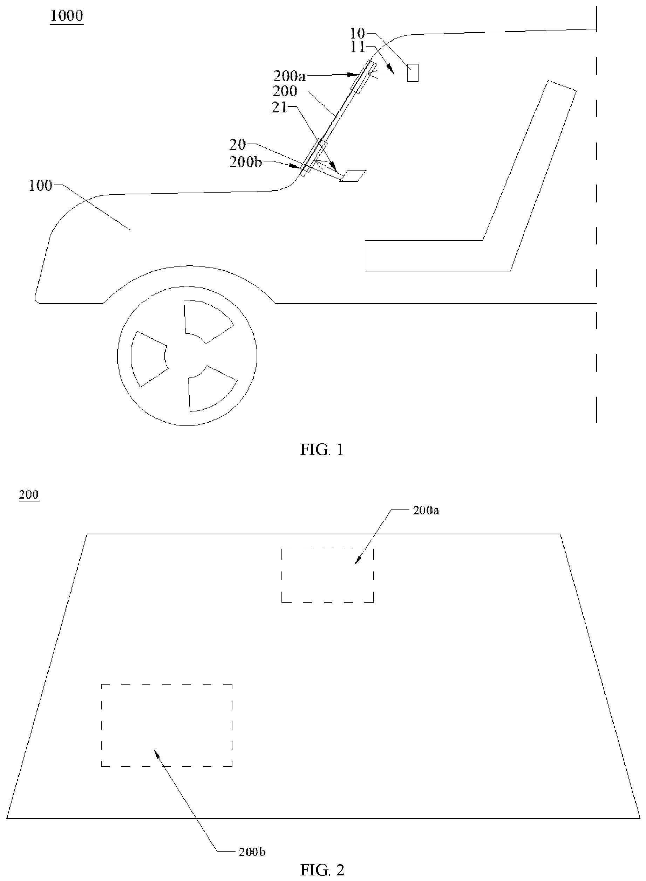

Reference can be made to FIG. 1, which is a schematic structural view of a vehicle 1000 provided in an embodiment of the present disclosure. The vehicle 1000 includes a vehicle body 100 and vehicle window glass 200. The vehicle window glass 200 is connected to the vehicle body 100. The vehicle window glass 200 may be a front windshield of the vehicle 1000.

It may be noted that, FIG. 1 merely aims to schematically describe the connection relationship between the vehicle body 100 and the vehicle window glass 200, and is not intended to specifically limit the connection position, specific configuration, and quantity of each device. The schematic structure of embodiments of the present disclosure does not constitute a specific limitation to the vehicle 1000. In other embodiments of the present disclosure, the vehicle 1000 may include more or fewer components than illustrated in FIG. 1, or combine or split certain components, or have different component arrangements. The components illustrated in FIG. 1 may be implemented in hardware, software, or a combination of software and hardware.

The vehicle 1000 further includes a detection assembly 10 and a projection assembly 20. The detection assembly 10 and the projection assembly 20 are mounted inside the vehicle 1000. The detection assembly 10 is configured to emit and/or receive detection light 11. The detection assembly 10 may be fixedly mounted on an inner surface of the vehicle window glass 200 or may be mounted at the vehicle body 100, such as, mounted on an inner surface of a roof of the vehicle. The projection assembly 20 is configured to emit the projection light 21. The projection assembly 20 may be mounted near a bottom edge of the vehicle window glass 200, such as, mounted inside a dashboard of the vehicle, or may be mounted near a top edge of the vehicle window glass 200, such as, mounted on the inner surface of the roof.

The detection assembly 10 is configured to emit detection light 11 towards the outside of the vehicle and/or receive detection light 11 incident from the outside of the vehicle to the inside of the vehicle. At least 80% of the detection light 11 is P-polarized light. Exemplarily, at least 90% of the detection light 11 may be P-polarized light. Further, 100% of the detection light 11 may P-polarized light (allowable tolerance range), that is, the projection light 21 is substantially pure P-polarized light. It can be understood that when a proportion of P-polarized light in the detection light 11 is higher, it is easier to improve the transmittance of the vehicle window glass 200 for the detection light 11.

Exemplarily, a wavelength of the detection light 11 of the detection assembly 10 may range from 850 nm to 1650 nm. The detection assembly 10 may include one or more of a LiDAR (that is, light detection and ranging) that emits and/or receive detection light 11 having a wavelength of 850 nm, 905 nm, 1064 nm, or 1550 nm, and/or a near-infrared camera that emits and/or receives detection light 11 having a wavelength ranging from 850 nm to 1650 nm. The LiDAR can accurately sense three-dimensional information of the environment outside the vehicle, detect and identify the specific contour, distance, speed, acceleration, and other information of obstacles such as pedestrians and other vehicles, and realize the functions of positioning and odometer. The near-infrared camera can shoot and image the external environment. As the autonomous driving level of the vehicle rises to above L2.5, even reaches L3, L4, and L5, the detection assembly 10 preferably adopts multiple LiDARs and/or multiple near-infrared cameras. For example, the detection assembly 10 simultaneously adopts a 905 nm LiDAR and a 1550 nm LiDAR. For another example, the detection assembly 10 simultaneously adopts a 940 nm near-infrared camera and a 1550 nm LiDAR. The vehicle window glass 200 in the present disclosure can meet the requirements for the simultaneous configuration of multiple LiDARs and/or multiple near-infrared cameras.

The projection assembly 20 is configured to emit projection light 21 towards the vehicle window glass 200. The projection light 21 can form a head-up display (HUD) image recognized by human eyes after being reflected by the vehicle window glass 200. The wavelength of the projection light 21 may range from 380nm to 780nm. At least 90% of the projection light 21 may be P-polarized light. Exemplarily, 100 % of the projection light 21 may be P-polarized light, that is, the projection light 21 is substantially pure P-polarized light. It can be understood that the projection assembly 20 can add a head-up display function to the vehicle 1000. When the proportion of P-polarized light in the projection light 21 is higher, it is easier to eliminate the visual ghost phenomenon of the head-up display image. In the present disclosure, P-polarized light is used for projection, so that compared to the conventional vehicle window glass that can only be used with the projection light of S-polarized light, the vehicle window glass 200 and the projection assembly 20 provided in the present disclosure can meet the use requirements of drivers wearing sunglasses.

The projection assembly 20 is configured to emit projection light 21 onto the vehicle window glass 200, where the projection light includes relevant texts and image information, such as speed, engine revolutions per minute (rpm), fuel consumption, tire pressure, dynamic navigation, night vision, or live map, so that a head-up display image located in front of the vehicle window glass is observed by an observer in the vehicle, therefore implementing head-up display (HUD) and even augmented reality-HUD (AR-HUD). The projection assembly 20 is a component known to those skilled in the art, which includes, but is not limited to, a laser, a light-emitting diode (LED), a liquid crystal display (LCD), digital light processing (DLP), electroluminescent (EL), a cathode ray tube (CRT), a vacuum fluorescent tube (VFD), a collimator lens, a spherical correction mirror, a convex lens, a concave lens, a reflection mirror, and/or a polarizer. Meanwhile, a position and an angle of incidence of the projection assembly 20 are adjustable to be adapted to different positions or heights of observers in the vehicle.

Reference can be made to FIG. 2, which is a schematic top view of the vehicle window glass 200 illustrated in FIG. 1. The vehicle window glass 200 may have a signal transmission region 200a and a head-up display region 200b. The signal transmission region 200a allows the detection light 11 of the detection assembly 10 to pass through. The head-up display region 200b is configured to reflect the projection light 21 of the projection assembly 20 to form a head-up display image. Exemplarily, there may be multiple signal transmission regions 200a and head-up display regions 200b, and the number and location of signal transmission regions 200a and head-up display regions 200b are not specifically limited in the present disclosure.

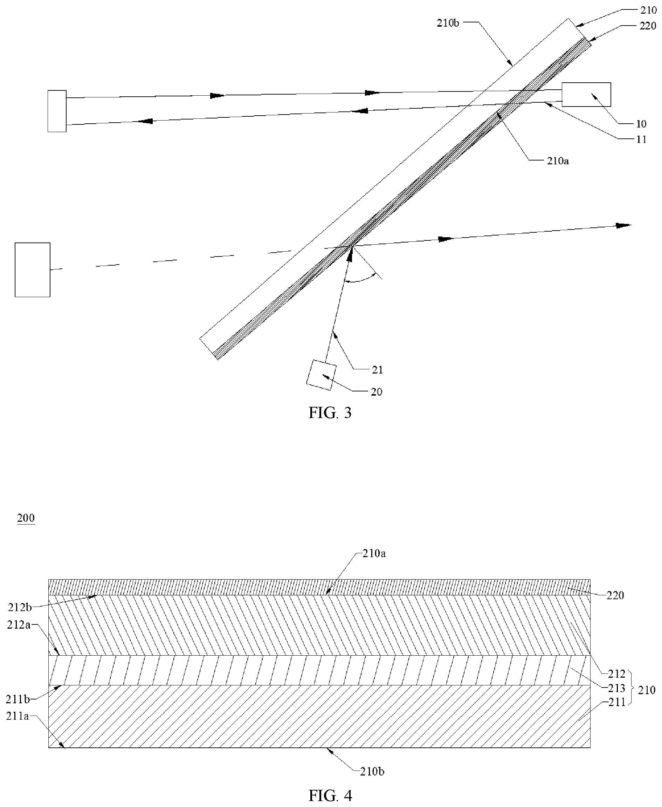

Reference can be made to FIG. 3, which is a schematic structural view of the vehicle window glass 200 illustrated in FIG. 1. The vehicle window glass 200 may include a glass substrate 210 and a transparent nano coating 220 disposed on a surface of the glass substrate 210. The glass substrate 210 has an outer surface 210b and an inner surface 210a opposite to the outer surface 210a. The transparent nano coating 220 is disposed on the inner surface 210a. The outer surface 210b is a surface of the glass substrate 210 facing the outside of the vehicle after the vehicle window glass 200 is connected to the vehicle body 100. The inner surface 210a is a surface of the glass substrate 210 facing the inside of the vehicle after the vehicle window glass 200 is connected to the vehicle body 100. The transparent nano coating 220 can improve both the transmittance of the vehicle window glass 200 for the detection light 11 of the detection assembly 10 and the reflectivity of the vehicle window glass 200 for the projection light 21 of the projection assembly 20, so that the vehicle window glass 200 can meet the use requirements of both the detection assembly 10 and the projection assembly 20. It can be understood that the vehicle window glass 200 can have a high transmittance for the detection light 11 to meet the high-precision operation requirements of the detection assembly 10, and can have a high reflectivity for the projection light 21 to form a sharp head-up display image without visual ghosting. It is preferable that the transmittance of the vehicle window glass 200 for the detection light 11 incident at an incident angle of 50° to 73° is greater than or equal to 80%, and the reflectivity of the vehicle window glass 200 for the projection light 21 incident on at an incident angle of 45° to 85° on the surface of the vehicle window glass 200 facing the inside of the vehicle is greater than or equal to 20%. Exemplarily, the detection assembly 10 is a 905 nm LiDAR and/or a 1550 nm LiDAR. The detection assembly 10 is configured to emit and receive the detection light 11 passing through the vehicle window glass 200. The vehicle window glass 200 is mounted on the vehicle body 100 at an inclined angle of 25°. The detection light 11 is configured to pass through the signal transmission region 200a of the vehicle window glass 200 at an incident angle of approximately 65°. The transmittance of the vehicle window glass 200 for the detection light 11 is greater than or equal to 80%. The projection light 21 is incident onto the head-up display region 200b of the vehicle window glass 200 at an incident angle of approximately 65° from the inside of the vehicle. The reflectivity of the vehicle window glass 200 for the projection light 21 is greater than or equal to 20%.

The wavelength of the projection light 21 may range from 380 nm to 780 nm, which is related to the spectral range of visible light perceivably by human eyes. The wavelength range of the projection light 21 also covers the wavelength RGB related to the projection assembly 20: 469 nm (blue), 529 nm (green), and 629 nm (red). Therefore, the vehicle window glass 200 in the present disclosure can cooperate with the projection assembly 20 to realize full-color display of the head-up display image.

Reference can be made to FIG. 4, which is a schematic structural view of a glass substrate 210 illustrated in FIG. 3 being laminated glass. The glass substrate 210 is laminated glass and includes outer glass 211, inner glass 212, and an intermediate layer 213 disposed between the outer glass 211 and the inner glass 212. The outer glass 211 has a first surface 211a and a second surface 211b opposite to the first surface 211a. The first surface 211a is away from the intermediate layer 213. The second surface 211b is connected to the intermediate layer 213. The first surface 211a also serves as the outer surface 210b of the glass substrate 210. The inner glass 212 has a third surface 212a and a fourth surface 212b opposite to the third surface 212a. The third surface 212a is connected to the intermediate layer 213. The fourth surface 212b is away from the intermediate layer 213. The fourth surface 212b also serves as the inner surface 210a of the glass substrate 210. The transparent nano coating 220 is disposed on the fourth surface 212b of the inner glass 212. The transmittance of the outer glass 211 and/or the inner glass 212 for near-infrared light having a wavelength ranging from 850 nm to 1650 nm is greater than or equal to 91%, and the visible light transmittance of the vehicle window glass 200 is greater than or equal to 70%, so that the requirements of laws and regulations for the front windshield of the vehicle 1000 are met.

It may be noted that the laminated glass serving as the front windshield is usually curved, but the shape of the laminated glass is not limited to the shape described above. The shape of the laminated glass can be any shape that meets the use requirements of the vehicle window glass 200, for example, the vehicle window glass 200 may also be in a flat plate shape. The shape of the vehicle window glass 200 is not strictly required in embodiments of the present disclosure. Exemplarily, the vehicle window glass 200 has a vertical radius of curvature in the direction from the bottom edge to the top edge. The vertical radius of curvature is 4000 mm to 10000 mm for the convenience of design and production of the vehicle window glass 200.

The outer glass 211 and the inner glass 212 may be ultra-transparent glass (ultra-clear glass). The content of iron oxide (Fe₂O₃) in ultra-transparent glass is relatively low. Each of the outer glass 211 and the inner glass 212 may contain 0 to 0.1% iron oxide (Fe₂O₃) by weight percentage. For example, the content of iron oxide (Fe₂O₃) in each of the outer glass 211 and the inner glass 212 is less than or equal to 0.09%, less than or equal to 0.08%, less than or equal to 0.07%, less than or equal to 0.05%, less than or equal to 0.04%, less than or equal to 0.03%, less than or equal to 0.02%, less than or equal to 0.015%, or less than or equal to 0.01%, or even the outer glass 211 and the inner glass 212 may be substantially free of iron oxide (Fe₂O₃). Exemplarily, the outer glass 211 and the inner glass 212 may be soda-lime-silica ultra-transparent glass, borosilicate glass, or high-alumina glass.

The intermediate layer 213 is used to connect the outer glass 211 and the inner glass 212, so that the whole vehicle window glass 200 presents a sandwich structure, to improve the safety of the vehicle window glass 200 and make it meet the safety standards and regulatory requirements of the vehicle window glass for vehicles 1000. The material of the intermediate layer 213 may be polyvinyl butyral (PVB), ethylene vinyl acetate (EVA), thermoplastic polyurethane elastomer (TPU), or ionic polymer film (SGP). Exemplarily, the intermediate adhesive layer may have a single-layer structure or a multilayer structure. For example, the multilayer structure includes a double-layer structure, a triple-layer structure, a quadruple-layer structure, a five-layer structure, and the like. The intermediate layer 213 may also have other functions such as providing at least one colored region as a shadow band to reduce the interference of sunlight to the eyes, or adding an infrared absorber to have a sunscreen or heat insulation function, or adding an ultraviolet absorber to have an ultraviolet insulation function, or at least one layer of the multi-layer structure has a higher plasticizer content to have a sound insulation function.

The conventional vehicle window glass 200 usually adopts wedge-shaped intermediate layer 213 with a wedge angle of at least 0.3 mrad to eliminate the image ghosting of head-up display, resulting in difficulty in design and production, and adjustment of the imaging effect of projection assembly 20. The vehicle window glass 200 provided in the present disclosure can adopt an ordinary equal-thickness intermediate layer 213 to directly replace the wedge-shaped intermediate layer, to save cost and reduce the difficulty of design, production, and adjustment. The wedge angle of the equal-thickness intermediate layer 213 is substantially equal to 0, and the cross-sectional shape of the equal-thickness intermediate layer 213 is substantially rectangular. It can be understood that the wedge-shaped intermediate layer 213 with a smaller wedge angle may also be adopted in the present disclosure, such as, the wedge-shaped intermediate layer 213 with a wedge angle of 0.01 mrad to 0.15mrad. For example, the wedge angle of the wedge-shaped intermediate layer 213 may be 0.01 mrad, 0.02 mrad, 0.03 mrad, 0.04 mrad, 0.05 mrad, 0.06 mrad, 0.07 mrad, 0.08 mrad, 0.09 mrad, 0.10 mrad, 0.11 mrad, 0.12 mrad, 0.13 mrad, 0.14 mrad, 0.15 mrad., etc. In this way, the transmitted ghosting generated by the scene in the external environment of the vehicle 1000 passing through the vehicle window glass 200 can be further eliminated. The wedge-shaped intermediate layer 213 with a small wedge angle can be obtained by a simple stretching process. Therefore, both the reflected ghosting and the transmitted ghosting can be eliminated at a low cost, and the higher-quality projection image and observation effect can be obtained.

The intermediate layer 213 may be a transparent intermediate layer or a tinted intermediate layer. The visible light transmittance of the intermediate layer 213 may be greater than or equal to 80%, preferably greater than or equal to 85%, and more preferably greater than or equal to 90%. The thickness of the intermediate layer 213 may be 0.38 mm to 1.6 mm, such as 0.38 mm, 0.5 mm, 0.76 mm, 1.14 mm, 1.52 mm, 1.6 mm, etc. Preferably, the intermediate layer 213 is a tinted intermediate layer having the visible light transmittance greater than or equal to 80%. The tinted intermediate layer can absorb P-polarized light having a wavelength ranging from 380 nm to 780 nm, so that it is easier to eliminate the visual ghosting phenomenon of the head-up display image. In addition, since the tinted intermediate layer has a specific color, it is unnecessary to pay too much attention to the reflected color of the transparent nano coating 220 when designing the transparent nano coating 220, thereby improving the design freedom of the transparent nano coating 220.

The transparent nano coating 220 is directly disposed on the fourth surface 212b of the glass substrate 210. The transparent nano coating 220 covers at least the signal transmission region 200a and the head-up display region 200b. The transparent nano coating 220 may cover at least 60%, or at least 70%, or at least 80%, or at least 90%, or even 100% of the area of the fourth surface 212b. The transparent nano coating 220 can meet both the requirement of high-precision operation of the detection assembly 10 and the requirement of sharp and non-visual ghosting of the head-up display image. Therefore, the transparent nano coating 220 can cover the signal transmission region 200a and the head-up display region 200b through a one-time deposition process, so that the conventional partition deposition process can be avoided, thereby reducing the process operations, reducing the production difficulty, and improving the production efficiency.

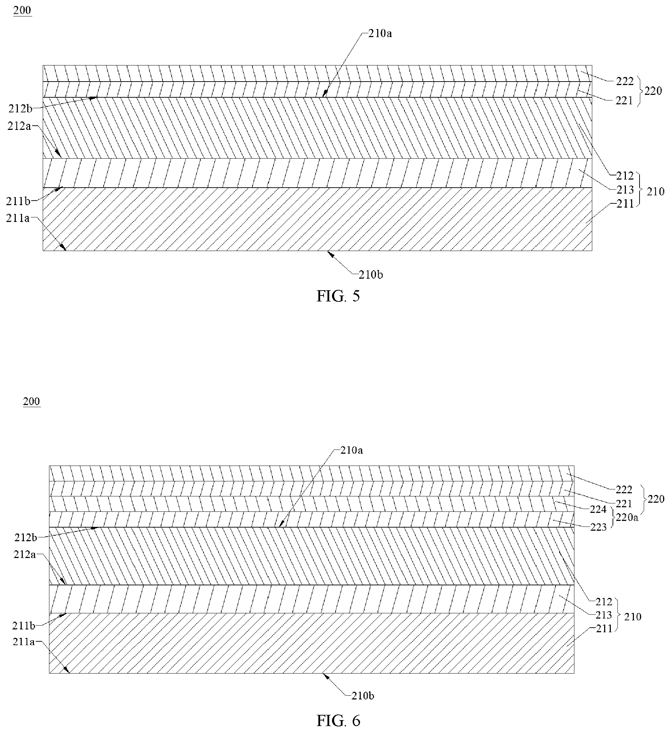

Reference can be made to FIG. 5, which is a schematic structural view of vehicle window glass 200 illustrated in FIG. 4 in a first possible implementation. The transparent nano coating 220 includes an enhanced high refractive-index layer 221 and an outermost low refractive-index layer 222. The enhanced high refractive-index layer 221 and the outermost low refractive-index layer 222 are sequentially laminated in a direction away from the fourth surface 212b. The refractive index of the enhanced high refractive-index layer 221 ranging from 2.60 to 2.72.

The thickness of the enhanced high refractive-index layer 221 may range from 35 nm to 70 nm. In some implementations, the thickness of the enhanced high refractive-index layer 221 may range from 45 nm to 65 nm. In some implementations, the enhanced high refractive-index layer 221 is a TiOₓ layer. A proportion of rutile-structured TiOₓ in the TiOₓ layer is at least 90%. TiOₓ usually has an anatase structure, a rutile structure, and a brookite structure. The rutile-structured TiOₓ has relatively high stability. After a high-temperature heat treatment of at least 560°C and the bending treatment, the proportion of the rutile-structured TiOₓ in the TiOₓ layer is preferably at least 90%, more preferably at least 95%, or even 100%, that is, the TiOₓ layer consists entirely of the rutile-structured TiOₓ. In some implementations, the refractive index *n* of the TiOₓ layer ranges from 2.60 to 2.72. The extinction coefficient k of the TiOₓ layer is greater than or equal to 0.0015.

The thickness of the outermost low refractive-index layer 222 may range from 75 nm to 130 nm. In some implementations, the thickness of the outermost low refractive-index layer 222 may range from 90 nm to 120 nm. In other implementations, the thickness of the outermost low refractive-index layer 222 may range from 85 nm to 130 nm. In further implementations, the thickness of the outermost low refractive-index layer 222 may range from 75 nm to 105 nm.

In embodiments of the present disclosure, the transparent nano coating 220 may further include at least one laminated structure 220a. Each of the at least one laminated structure 220a may include a high refractive-index layer and a low refractive-index layer. The material of the high refractive-index layer may be at least one of SiNₓO_{y}, SiBNₓO_{y}, SiTiNₓO_{y}, SiAlNₓO_{y}, SiZrNₓO_{y}, ZnOₓ, ZnAlOₓ, ZnOₓ, ZnSnOₓ, SiNₓ, SiAlNₓ, SiBNₓ, SiTiNₓ, SiZrNₓ, TiOₓ, NbOₓ, ZrOₓ, and the like, where 1 < x ≤ 3 and 1 < y < 3. The material of the low refractive-index layer may be at least one of silicon oxide (SiOₓ), borosilicate oxide (SiBOₓ), silicon aluminum oxide (SiAlOₓ), silicon titanium oxide (SiTiOₓ), silicon zirconium oxide (SiZrOₓ), and the like, where 1 < x < 3.

For the specific structure of the laminated structure 220a, please refer to the following related descriptions in the second possible implementation and the third possible implementation.

### A first possible implementation

Referring to FIG. 5 again, in the first possible implementation, the transparent nano coating 220 has a two-layer structure, and the two-layer structure includes an enhanced high refractive-index layer 221 and an outermost low refractive-index layer 222. The enhanced high refractive-index layer 221 and the outermost low refractive-index layer 222 are sequentially disposed on the fourth surface 212b of the inner glass 212.

The material of the enhanced high refractive-index layer 221 is titanium oxide (TiOx, where 1.8 ≤ x ≤ 2). The refractive index *n* of the enhanced high refractive-index layer 221 ranges from 2.60 to 2.72 (both inclusive). The thickness of the enhanced high refractive-index layer 221 ranges from 45 nm to 65 nm (both inclusive). For example, the refractive index of the enhanced high refractive-index layer 221 may be 2.62, 2.64, 2.65, 2.69, 2.70, 2.72, etc. The refractive index *n* of the outermost low refractive-index layer 222 ranges from 1.35 to 1.60 (both inclusive). For example, the refractive index of the outermost low refractive-index layer 222 may be 1.35, 1.40, 1.45, 1.50, 1.55, 1.60, etc. The material of the outermost low refractive-index layer 222 may be one of SiOₓ, SiBOₓ, SiAlOₓ, SiTiOₓ, SiZrOₓ, and the like, where 1 < x < 3. The thickness of the outermost low refractive-index layer 222 may range from 90 nm to 120 nm (both inclusive).

This implementation further provides two examples and two comparative examples, to study the performance of the vehicle window glass 200 in the first implementation.

### Example 1

Vehicle window glass 200 provided in example 1 includes a glass substrate 210, and an enhanced high refractive-index layer 221 and an outermost low refractive-index layer 222 that are sequentially disposed on a fourth surface 212b of the glass substrate 210. Each of outer glass 211 and inner glass 212 of the glass substrate 210 is ultra-clear glass, and has the thickness of 2.1 mm. A material of an intermediate layer 213 connecting the outer glass 211 and the inner glass 212 is equal-thickness PVB. The thickness of the intermediate layer 213 is 0.76 mm.

The enhanced high refractive-index layer 221 is made of TiOₓ with a refractive index equal to 2.69, and has the thickness of 61.6 nm.

The outermost low refractive-index layer 222 is made of SiO₂, and has the thickness of 98 nm.

The enhanced high refractive-index layer 221 is formed by magnetron sputtering. A target power supply for magnetron sputtering of the enhanced high refractive-index layer 221 is a high-power impulse magnetron sputtering (HiPIMS) power supply. The outermost low refractive-index layer 222 is formed by magnetron sputtering. A target power supply for magnetron sputtering of the outermost low refractive-index layer 222 is a mid-range frequency (MF) magnetron sputtering power supply.

### Example 2

The same parts of example 2 as those of example 1 will not be repeated. Example 2 is different from example 1 as follows. In example 2, the enhanced high refractive-index layer 221 is made of TiOₓ with a refractive index equal to 2.70, and has the thickness of 57.6 nm. The thickness of the outermost low refractive-index layer 222 is 113.8 nm.

### Comparative example 1

The same parts of comparative example 1 as those of example 1 will not be repeated. Comparative example 1 is different from example 1 as follows. The vehicle window glass 200 in comparative example 1 is not provided with the transparent nano coating 220.

### Comparative example 2

The same parts of comparative example 2 as those of example 1 will not be repeated. Comparative example 2 is different from example 1 as follows. In comparative example 2, the enhanced high refractive-index layer 221 is made of TiOₓ with a refractive index equal to 2.50, and the target power supply during magnetron sputtering is the MF magnetron sputtering power supply.

The vehicle window glass 200 in each of comparative examples 1-2 and examples 1-2 is integrated with the detection assembly 10 and the projection assembly 20. The reflectivity Rp, Lab values of reflected color, visible light transmittance, and P-polarized light transmittance are measured and calculated.

The projection assembly 20 can emit projection light 21 having a wavelength ranging from 380 nm to 780 nm. At least 99% of the projection light 21 is P-polarized light.

The detection assembly 10 can emit and receive detection light 11 having the wavelength of 905 nm and 1550 nm. At least 99% of the detection light 11 is P-polarized light.

P-polarized light transmittance: a transmittance of the vehicle window glass 200 for detection light incident at different incident angles, measured from one side of the vehicle window glass 200 where the nano transparent coating 220 is disposed; and transmittances of the vehicle window glass 200 for detection light having the wavelength of 905 nm and 1550 nm, incident at the incident angle of each of 50°, 55°, 60°, 65°, 70°, and 73°, are recorded, denoted as T(905 nm) and T(1550 nm), respectively.

P-polarized light reflectivity: a reflectivity of the vehicle window glass 200 for projection light 21 incident at the incident angle of 65°, measured from one side of the vehicle window glass 200 provided with the nano transparent coating 220; and reflectivity Rf of the vehicle window glass 200 for projection light 21 having the wavelength of each of 469 nm (blue), 529 nm (green), and 629 nm (red) is recorded.

Visible light transmittance TL: calculated according to ISO9050.

Reflected color *L, a, b:* when light of a D65 light source is emitted onto the vehicle window glass 200 and measured from the outer surface of the vehicle window glass 200, *L,* the value of *a,* and the value of *b* are calculated according to CIE (International Commission on illumination) Lab color space, based on the D65 light source and a field of view of 10°, where L represents brightness, *a* represents red-green value, and *b* represents yellow-blue value.

The measurement results of comparative examples 1-2 and example 1-2 are recorded in Table 1.

**Table 1 Measurement results of vehicle window glass in each of comparative examples 1-2 and examples 1-2**

| | | Example 1 | Example 2 | Comparative example 1 | Comparative example 2 |
|---|---|---|---|---|---|
| Enhanced high refractive-index layer 221 | Thickness | 61.6nm | 57.6nm | / | 61.6nm |
| | Target power supply | HiPIMS | HiPIMS | / | MF |
| | Refractive index *n* | 2.69 | 2.70 | / | 2.50 |
| | *k* (extinction coefficient) | 0.00425 | 0.00226 | / | 0.00034 |
| | Rf(469nm)-65° | 21.2% | 22.2% | 23% | 19.9% |
| P-polarized light reflectivity | Rf(529nm)-65° | 24.2% | 25.2% | 2.4% | 20.3% |
| | Rf(629nm)-65° | 21.3% | 22.4% | 2.4% | 15.9% |
| Lab values | *L* | 48.1 | 53.4 | 32.9 | 43.8 |
| | *a* | -1.4 | -7 | -0.2 | 0.8 |
| | *b* | -5.2 | -10.5 | 0.5 | -11.5 |
| Visible light transmittance | TL | 76.9% | 72.2% | 87.2% | 80.5% |
| P-polarized light transmittance at 1550 nm | T(1550nm)-50° | 81.3% | 82.0% | 89.5% | 84.2% |
| | T(1550nm)-55° | 83.7% | 84.3% | 89.8% | 86.2% |
| | T(1550nm)-60° | 85.7% | 86.1% | 89.3% | 87.5% |
| | T(1550nm)-65° | 86.4% | 86.6% | 87.1% | 87.5% |
| | T(1550nm)-70° | 84.3% | 84.3% | 81.8% | 84.5% |
| | T(1550nm)-73° | 80.7% | 80.5% | 76.5% | 80.3% |
| P-polarized light transmittance at 905 nm | T(905nm)-50° | 81.8% | 83.3% | 96.1% | 86.6% |
| | T(905nm)-55° | 84.2% | 85.1% | 96.6% | 88.8% |
| | T(905nm)-60° | 86.2% | 86.5% | 96.2% | 90.6% |
| | T(905nm)-65° | 87.1% | 86.6% | 94.0% | 91.0% |
| | T(905nm)-70° | 85.3% | 84.0% | 88.6% | 88.6% |
| | T(905nm)-73° | 81.8% | 80.2% | 82.9% | 84.6% |

By comparison, it can be seen that since there is no transparent nano coating 220, the P-polarized light reflectively in comparative example 1 is far less than 20%, and even the P-polarized light reflectivity Rf at the wavelength of each of 469 nm, 529 nm, and 629 nm is less than 3%, so that the vehicle window glass 200 in comparative example 1 is unable to realize the head-up display function. In addition, the transmittance for P-polarized light having the wavelength of 1550 nm incident at an incident angle of 50° to 73° significantly drops to less than 80%, so that the vehicle window glass 200 in comparative example 1 is unable to meet the detection requirements of a 1550 nm LiDAR at the incident angle of 73°.

Although the transparent nano coating 220 is provided in comparative example 2, the enhanced high refractive-index layer 221 in the transparent nano coating 220 is deposited by using a conventional MF magnetron sputtering power supply. After the transparent nano coating 220 and the inner glass 212 are subjected to the high-temperature heat treatment of at least 560°C and the bending treatment, such as the baking and bending process for vehicle glass, a TiOₓ layer with the refractive index *n* less than 2.6 and the extinction coefficient *k* less than 0.001 is obtained as the enhanced high refractive-index layer 221. Although the vehicle window glass 200 in comparative example 2 can meet the high transmittance requirement for P-polarized light of each of a 905 nm LiDAR and a 1550 nm LiDAR incident at the incident range of 50° to 73°, where the high transmittance is greater than or equal to 80%, the reflectivity Rf of the vehicle window glass 200 in comparative example 2 for P-polarized light having the wavelength of each of 469 nm and 629 nm is less than 20%, and even less than 16%. As a result, the brightness of the head-up display image may be insufficient, necessitating the use of a higher-power projection assembly 20, which, however, is not conducive to the heat dissipation of the projection assembly 20.

Lab values of the reflected color and visible light transmittance TL of the vehicle window glass 200 in each of examples 1-2 indicate that the vehicle window glass 200 can meet the safety requirements for the vehicle 1000 to use and can exhibit a beautiful light blue color when the vehicle window glass 200 is viewed from the outside of the vehicle.

In each of example 1 and example 2, the transparent nano coating 220 is provided and the enhanced high refractive-index layer 221 is deposited by using a HiPIMS power supply, and after the transparent nano coating 220 and the inner glass 212 are subjected to the high-temperature heat treatment of at least 560°C and the bending treatment, such as, the baking and bending process for vehicle glass, a TiOx layer with refractive index n greater than or equal to 2.6 and extinction coefficient k greater than or equal to 0.002 is obtained as the enhanced high refractive-index layer 221. Compared to comparative example 1 and comparative example 2, the vehicle window glass 200 in each of example 1 and example 2 cannot only meet the high transmittance requirement that the transmittance of the vehicle window glass 200 for P-polarized light of each of a 905 nm LiDAR and a 1550 nm LiDAR greater than or equal to 80% incident at an incident angle of 50° to 73°, but also realize that the reflectivity of the vehicle window glass 200 for P-polarized light having the wavelength of each of 469 nm, 529 nm, and 629 nm is greater than or equal to 21%, and simultaneously meet the use requirement of cooperation of the detection assembly 10 and the projection assembly 20. In addition, a range of reflectivities of the vehicle window glass 200 for P-polarized light having wavelengths of 469 nm, 529 nm, and 629 nm is less than or equal to 3%. In other words, the maximum among Rf(469nm), Rf(529nm), and Rf(629nm) minus the minimum among Rf(469nm), Rf(529nm), and Rf(629nm) is less than or equal to 3%, so that the reflection spectrum for P-polarized light is smooth, and the head-up display image is displayed in neutral color.

### A second possible implementation

Reference can be made to FIG. 6, which is a schematic structural view of vehicle window glass 200 illustrated in FIG. 4 in a second possible implementation.

In the second possible implementation, the transparent nano coating 220 has a four-layer structure. The transparent nano coating 220 includes a laminated structure 220a, an enhanced high refractive-index layer 221, and an outermost low refractive-index layer 222. The laminated structure 220a includes a first high refractive-index layer 223 and a first low refractive-index layer 224. The first high refractive-index layer 223, the first low refractive-index layer 224, the enhanced high refractive-index layer 221, and the outermost low refractive-index layer 222 are sequentially disposed on the fourth surface 212b. The thickness of the first high refractive-index layer 223 may range from 2 nm to 190 nm (both inclusive). The thickness of the first low refractive-index layer 224 may range from 5 nm to 95 nm (both inclusive). The thickness of the enhanced high refractive-index layer 221 may range from 45 nm to 65 nm (both inclusive). The thickness of the outermost low refractive-index layer 222 may range from 85 nm to 130 nm (both inclusive).

This implementation provides three examples and a comparative example, to study the performance of the vehicle window glass 200 in the second implementation.

### Example 3

Vehicle window glass 200 provided in example 3 includes a glass substrate 210, and a first high refractive-index layer 223, a first low refractive-index layer 224, an enhanced high refractive-index layer 221, and an outermost low refractive-index layer 222 that are sequentially disposed on the fourth surface 212b of the glass substrate 210. Each of the outer glass 211 and the inner glass 212 of the glass substrate 210 is ultra-clear glass, and has the thickness of 2.1 mm. The material of the intermediate layer 213 connecting the outer glass 211 and the inner glass 212 is equal-thickness PVB. The thickness of the intermediate layer 213 is 0.76 mm.

The first high refractive-index layer 223 is made of TiOₓ with a refractive index equal to 2.50, and has the thickness of 5.5 nm.

The first low refractive-index layer 224 is made of SiO₂, and has the thickness of 9.8 nm.

The enhanced high refractive-index layer 221 is made of TiOₓ with a refractive index equal to 2.64, and has the thickness of 49.7 nm.

The outermost low refractive-index layer 222 is made of SiO₂, and has the thickness of 119.2 nm.

The first high refractive-index layer 223, the first low refractive-index layer 224, the enhanced high refractive-index layer 221, and the outermost low refractive-index layer 222 are all formed by magnetron sputtering. A target power supply for magnetron sputtering of each of the first high refractive-index layer 223, the first low refractive-index layer 224, and the outermost low refractive-index layer 222 is a MF magnetron sputtering power supply. A target power supply for magnetron sputtering of the enhanced high refractive-index layer 221 is a HiPIMS power supply.

### Example 4

The same parts of example 4 as those of example 3 will not be repeated. Example 4 is different from example 3 as follows. In example 4, the first high refractive-index layer 223 is made of SiNₓ and has the thickness of 4.3 nm. The enhanced high refractive-index layer 221 is made of TiOₓ with a refractive index equal to 2.62, and has the thickness of 55.9 nm. The outermost low refractive-index layer 222 has the thickness of 110.5 nm.

### Example 5

The same parts of example 5 as those of example 3 will not be repeated. Example 5 is different from example 3 as follows. In example 5, the first high refractive-index layer 223 is made of SiOₓN_{y}, and has the thickness of 172 nm. The thickness of the second low refractive-index layer 226 is 75.8 nm. The enhanced high refractive-index layer 221 is made of TiOₓ with a refractive index equal to 2.72, and has the thickness of 61.8 nm. The thickness of the outermost low refractive-index layer 222 is 92.4 nm.

### Comparative example 3

The same parts of comparative example 3 as those of example 5 will not be repeated. Comparative example 3 is different from example 5 as follows. In comparative example 3, the first high refractive-index layer 223 is made of TiOₓ with a refractive index equal to 2.50, the enhanced high refractive-index layer 221 is made of TiOₓ with a refractive index equal to 2.50, and the power supply used during magnetron sputtering of the enhanced high refractive-index layer 221 is a MF magnetron sputtering power supply.

The vehicle window glass 200 in each of comparative example 3 and examples 3-5 is integrated with the detection assembly 10 and the projection assembly 20. The reflectivity Rp, Lab values of reflected color, visible light transmittance, and P-polarized light transmittance are measured and calculated. The measurement results of each of comparative example 3 and examples 3-5 are recorded in Table 2 in the same manner as in example 1 and example 2.

**Table 2 Measurement results of vehicle window glass in each of comparative example 3 and examples 3-5**

| | | Example 3 | Example 4 | Example 5 | Comparative example 3 |
|---|---|---|---|---|---|
| Enhanced high refractive-index layer 221 | Thickness | 49.7nm | 55.9nm | 61.8nm | 61.8nm |
| | Target power supply | HiPIMS | HiPIMS | HiPIMS | MF |
| | Refractive index *n* | 2.64 | 2.62 | 2.72 | 2.50 |
| | *k* (extinction coefficient) | 0.00332 | 0.00241 | 0.00262 | 0.00034 |
| P-polarized light reflectivity | Rf(469nm)-65° | 21.2% | 22.0% | 23.7% | 21.6% |
| | Rf(529nm)-65° | 24.0% | 24.8% | 23.7% | 19.6% |
| | Rf(629nm)-65° | 21.3% | 21.9% | 23.6% | 17.9% |
| Lab values | L | 52.6 | 53.1 | 50.7 | 46.58 |
| | a | -7.6 | -7.1 | 0.6 | 4.2 |
| | b | -11.5 | -10.9 | -16.4 | -22.5 |
| Visible light transmittance | TL | 72.7% | 72.4% | 74.2% | 78.0% |
| P-polarized light transmittance at 1550 nm | T(1550nm)-50° | 82.5% | 82.1% | 82.3% | 86.9% |
| | T(1550nm)-55° | 84.7% | 84.4% | 84.6% | 87.9% |
| | T(1550nm)-60° | 86.4% | 86.2% | 86.2% | 88.3% |
| | T(1550nm)-65° | 86.7% | 86.6% | 86.5% | 87.4% |
| | T(1550nm)-70° | 84.3% | 84.3% | 84.2% | 83.6% |
| | T(1550nm)-73° | 80.4% | 80.5% | 80.2% | 79.1% |
| P-polarized light transmittance at 905 nm | T(905nm)-50° | 84.5% | 83.6% | 81.6% | 86.8% |
| | T(905nm)-55° | 86.0% | 85.3% | 85.3% | 90.1% |
| | T(905nm)-60° | 87.1% | 86.6% | 88.6% | 92.8% |
| | T(905nm)-65° | 86.9% | 86.7% | 90.3% | 93.7% |
| | T(905nm)-70° | 84.0% | 84.0% | 89.0% | 91.4% |
| | T(905nm)-73° | 80.0% | 80.1% | 85.6% | 87.3% |

By comparison, it can be seen that the enhanced high refractive-index layer 221 in comparative example 3 is deposited by using the conventional MF magnetron sputtering power supply, and after the transparent nano coating 220 and the inner glass 212 are subjected to the high-temperature heat treatment of at least 560°C and the bending treatment, such as, the baking and bending process for vehicle glass, a TiOₓ layer with a refractive index n less than 2.6 and an extinction coefficient k less than 0.001 is obtained as the enhanced high refractive-index layer 221. In comparative example 3, the transmittance of the vehicle window glass 200 for P-polarized light having the wavelength of 1550 nm incident at the incident angle of 50° to 73° significantly drops to less than 80%, so that the vehicle window glass 200 in comparative example 3 is unable to meet the detection requirements of a 1550 nm LiDAR at the incident angle of 73°. In comparative example 3, the reflectivity Rf of the vehicle window glass 200 for P-polarized light having the wavelength of each of 529 nm and 629 nm is less than 20%. As a result, the brightness of the head-up display image may be insufficient, necessitating the use of a higher-power projection assembly 20, which, however, is not conducive to the heat dissipation of the projection assembly 20.

A reflected color of the vehicle window glass 200 in comparative example 3 has a value of *a* greater than 4 in a color space Lab, and thus is reddish. Lab values of the reflected color and visible light transmittance TL of the vehicle window glass 200 in each of examples 3-5 also indicate that the vehicle window glass 200 can meet the safety requirements for the vehicle 1000 to use and can exhibit a beautiful light blue color when the vehicle window glass 200 is viewed from the outside of the vehicle 1000.

In each of examples 3-5, the enhanced high refractive-index layer 221 is deposited by using a HiPIMS power supply, and after the transparent nano coating and the inner glass are subjected to the high-temperature heat treatment of at least 560°C and the bending treatment, such as, the baking and bending process for vehicle glass, a TiOₓ layer with refractive index n greater than or equal to 2.6 and extinction coefficient k greater than or equal to 0.002 is obtained as the enhanced high refractive-index layer 221. Compared to comparative example 3, the vehicle window glass 200 in each of examples 3-5 cannot only meet the high transmittance requirement that the transmittance of the vehicle window glass 200 for the P-polarized light of each of a 905 nm LiDAR and a 1550 nm LiDAR greater than or equal to 80% incident at the incident angle of 50° to 73°, but also realize that the reflectivity of the vehicle window glass 200 for P-polarized light having the wavelength of each of 469 nm, 529 nm, and 629 nm is greater than or equal to 21%, and simultaneously meet the use requirement of cooperation of the detection assembly 10. In addition, a range of reflectivities of the vehicle window glass 200 for P-polarized light having wavelengths of 469 nm, 529 nm, and 629 nm is less than or equal to 3%. In other words, the maximum among Rf(469nm), Rf(529nm), and Rf(629nm) minus the minimum among Rf(469nm), Rf(529nm), and Rf(629nm) is less than or equal to 3%, even less than or equal to 2%, and even less than or equal to 1%, so that the reflection spectrum for P-polarized light is smooth, and the head-up display image is displayed in neutral color.

### A third possible implementation

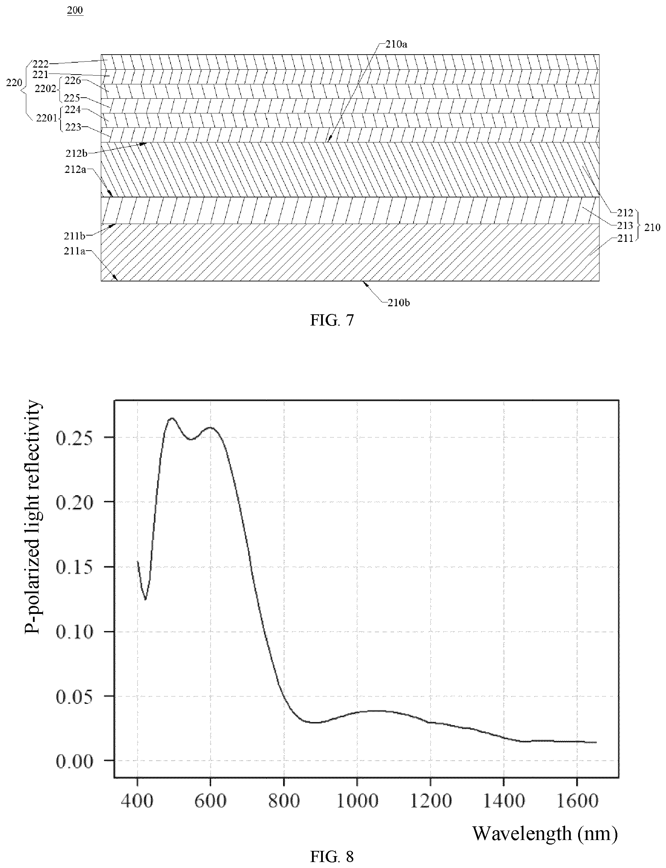

Reference can be made to FIG. 7, which is a schematic structural view of vehicle window glass 200 illustrated in FIG. 4 in a third possible implementation.

In the third possible implementation, the transparent nano coating 220 has a six-layer structure. The transparent nano coating 220 includes two laminated structures 220a, that is, a first laminated structure 2201 and a second laminated structure 2202. The first laminated structure 2201 includes a first high refractive-index layer 223 and a first low refractive-index layer 224. The second laminated structure 2202 includes a second high refractive-index layer 225 and a second low refractive-index layer 226. The first high refractive-index layer 223, the first low refractive-index layer 224, the second high refractive-index layer 225, the second low refractive-index layer 226, the enhanced high refractive-index layer 221, and the outermost low refractive-index layer 222 are sequentially disposed on the fourth surface 212b. The thickness of the first high refractive-index layer 223 may range from 140 nm to 190 nm (both inclusive). The thickness of the first low refractive-index layer 224 may range from 5 nm to 95 nm (both inclusive). The thickness of the second high refractive-index layer 225 may range from 130 nm to 205 nm (both inclusive). The thickness of the second low refractive-index layer 226 may range from 25 nm to 90 nm (both inclusive). The thickness of the enhanced high refractive-index layer 221 may range from 45 nm to 65 nm (both inclusive). The thickness of the outermost low refractive-index layer 222 may range from 75 nm to 105 nm (both inclusive).

This implementation further provides two examples and a comparative example, to study the performance of the vehicle window glass 200 in the third implementation.

### Example 6

The vehicle window glass 200 provided in example 6 includes a glass substrate 210, and a first high refractive-index layer 223, a first low refractive-index layer 224, a second high refractive-index layer 225, a second low refractive-index layer 226, an enhanced high refractive-index layer 221, and an outermost low refractive-index layer 222 that are sequentially disposed on the fourth surface 212b of the glass substrate 210.

The first high refractive-index layer 223 is made of SiOₓN_{y}, and has the thickness of 156.8 nm.

The first low refractive-index layer 224 is made of SiO₂, and has the thickness of 8.9 nm.

The second high refractive-index layer 225 is made of ZnSnO₃, and has the thickness of 150 nm.

The second low refractive-index layer 226 is made of SiO₂, and has the thickness of 62.8 nm.

The enhanced high refractive-index layer 221 is made of TiOₓ with a refractive index equal to 2.65, and has the thickness of 62.4 nm.

The outermost low refractive-index layer 222 is made of SiO₂, and has the thickness of 85.1 nm.

The first high refractive-index layer 223, the first low refractive-index layer 224, the second high refractive-index layer 225, the second low refractive-index layer 226, the enhanced high refractive-index layer 221, and the outermost low refractive-index layer 222 are all formed by magnetron sputtering. A target power supply for magnetron sputtering of each of the first high refractive-index layer 223, the first low refractive-index layer 224, the second high refractive-index layer 225, the second low refractive-index layer 226, and the outermost low refractive-index layer 222 is a MF magnetron sputtering power supply. A target power supply for magnetron sputtering of the enhanced high refractive-index layer 221 is a HiPIMS power supply.

### Example 7

The same parts of example 7 as those of example 6 will not be repeated. Example 7 is different from example 6 as follows. In example 7, the thickness of the first high refractive-index layer 223 is 166.8 nm. The thickness of the first low refractive-index layer 224 is 56.6 nm. The second high refractive-index layer 225 is made of SiOₓN_{y}, and has the thickness of 194.8 nm. The thickness of the second low refractive-index layer 226 is 79.1 nm. The enhanced high refractive-index layer 221 is made of TiOₓ with a refractive index equal to 2.72, and has the thickness of 59.6 nm. The thickness of the outermost low refractive-index layer 222 is 91.9 nm.

### Comparative example 4

The same parts of comparative example 4 as those of example 6 will not be repeated. Comparative example 4 is different from example 6 as follows. The enhanced high refractive-index layer 221 is made of TiOₓ with a refractive index equal to 2.50. A target power supply used during magnetic sputtering of the enhanced high refractive-index layer 221 is a MF magnetron sputtering power supply.

The vehicle window glass 200 of in each of comparative example 4 and examples 6-7 is integrated with the detection assembly 10 and the projection assembly 20. The reflectivity Rp, Lab values of reflected color, visible light transmittance, and P-polarized light transmittance are measured and calculated. The measurement results of each of comparative example 4 and examples 6-7 are recorded in Table 3 in the same way as in example 1 and example 2.

**Table 3 Measurement results of vehicle window glass 200 in each of comparative example 4 and examples 6-7**

| | | Example 6 | Example 7 | Comparative example 4 |
|---|---|---|---|---|
| Enhanced high refractive-index layer 221 | Thickness | 62.4nm | 59.6nm | 62.4nm |
| | Target power supply | HiPIMS | HiPIMS | MF |
| | Refractive index *n* | 2.65 | 2.72 | 2.50 |
| | *k* (extinction coefficient) | 0.00189 | 0.00323 | 0.00034 |
| P-polarized light reflectivity | Rf(469nm)-65° | 25.0% | 25.8% | 22.5% |
| | Rf(529nm)-65° | 25.1% | 23.6% | 19.6% |
| | Rf(629nm)-65° | 24.8% | 24.3% | 18.9% |
| Lab values | L | 52.9 | 53 | 49.3 |
| | a | 1.7 | 1.6 | 4.3 |
| | b | -14.4 | -23 | -19.2 |
| Visible light transmittance | TL | 76.7% | 71.8% | 80.2% |
| 1550 nm P-polarized light transmittance | T(1550nm)-50° | 90.8% | 82.3% | 92.5% |
| | T(1550nm)-55° | 92.0% | 84.7% | 93.2% |
| | T(1550nm)-60° | 92.4% | 86.5% | 93.1% |
| | T(1550nm)-65° | 91.3% | 86.7% | 91.3% |
| | T(1550nm)-70° | 87.2% | 84.0% | 86.6% |
| | T(1550nm)-73° | 82.4% | 80.0% | 81.4% |
| 905 nm P-polarized light transmittance | T(905nm)-50° | 82.9% | 84.5% | 86.8% |
| | T(905nm)-55° | 84.9% | 88.9% | 88.3% |
| | T(905nm)-60° | 86.3% | 92.0% | 89.1% |
| | T(905nm)-65° | 86.4% | 92.9% | 88.5% |
| | T(905nm)-70° | 83.8% | 90.2% | 85.0% |
| | T(905nm)-73° | 80.0% | 85.9% | 80.6% |

By comparison, it can be seen that the enhanced high refractive-index layer 221 in comparative example 4 is deposited by using the conventional MF magnetron sputtering power supply, and after the transparent nano coating 220 and the inner glass 212 are subjected to the high-temperature heat treatment of at least 560°C and the bending treatment, such as, the baking and bending process for vehicle glass, a TiOₓ layer with a refractive index n less than 2.6 and an extinction coefficient k less than 0.001 is obtained as the enhanced high refractive-index layer 221. In comparative example 4, the reflectivity Rf of the vehicle window glass 200 for P-polarized light having wavelengths of each of 529 nm and 629 nm is less than 20%. As a result, the brightness of the head-up display image may be insufficient, necessitating the use of a higher-power projection assembly 20, which, however, is not conducive to the heat dissipation of the projection assembly 20.

A reflected color of the vehicle window glass 200 in comparative example 4 has a value of *a* greater than 4 in a color space Lab, and thus is reddish. Lab values of the reflected color and visible light transmittance TL of the vehicle window glass 200 in each of examples 6-7 also indicate that the vehicle window glass 200 can meet the safety requirements for the vehicle 1000 to use and can exhibit a beautiful light blue color when the vehicle window glass 200 is viewed from the outside of the vehicle 1000.

In each of examples 6-7, the enhanced high refractive-index layer 221 is deposited by using a HiPIMS power supply, and after the transparent nano coating and the inner glass are subjected to the high-temperature heat treatment of at least 560°C and the bending treatment, such as, the baking and bending process for vehicle glass, a TiOₓ layer with refractive index n greater than or equal to 2.6 and extinction coefficient k greater than or equal to 0.0015 is obtained as the enhanced high refractive-index layer 221. Compared to comparative example 4, the vehicle window glass 200 in each of examples 6-7 cannot only meet the high transmittance requirement that the transmittance of the vehicle window glass 200 for the P-polarized light of each of a 905 nm LiDAR and a 1550 nm LiDAR greater than or equal to 80% incident at the incident angle of 50° to 73°, but also realize that the reflectivity of the vehicle window glass 200 for P-polarized light having the wavelength of each of 469 nm, 529 nm, and 629 nm is greater than or equal to 23% to realize the head-up display image with high brightness. In addition, a range of reflectivities of the vehicle window glass 200 for P-polarized light having wavelengths of 469 nm, 529 nm, and 629 nm is less than or equal to 3%. In other words, the maximum among Rf(469nm), Rf(529nm), and Rf(629nm) minus the minimum among Rf(469nm), Rf(529nm), and Rf(629nm) is less than or equal to 3%, even less than or equal to 2%, and even less than or equal to 1%, so that the reflection spectrum for P-polarized light is smooth, and the head-up display image is displayed in neutral color.

Reference can be made to FIG. 8, which is a graph of a spectral reflectivity of the vehicle window glass, provided in example 6, for P-polarized light having a wavelength of 400nm to 1600nm incident at an incident angle of 65°. FIG. 8 shows the following. The reflectivity of the vehicle window glass 200 for P-polarized light having the wavelength of each of 469 nm, 529 nm, and 629 nm is greater than or equal to 24%. The reflectivity of the vehicle window glass 200 for P-polarized light having the wavelength of 905 nm is only 2.5%. The reflectivity of the vehicle window glass 200 for P-polarized light having the wavelength of 1550 nm is only 1.4%. Therefore, the vehicle window glass 200 can meet the use requirement of cooperation of the detection assembly 10 and the projection assembly 20.

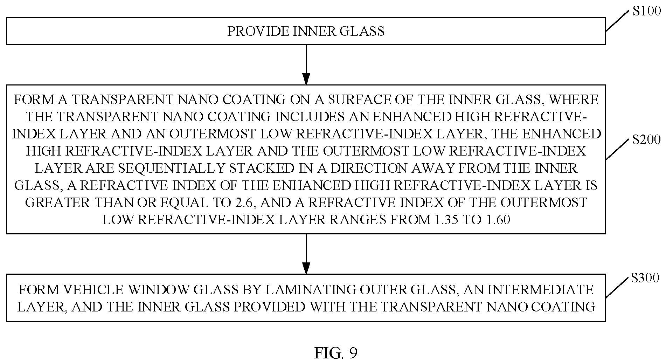

The present disclosure further provides a manufacturing method for vehicle window glass 200. Reference can be made to FIG. 9, which is a flow chart of a manufacturing method for vehicle window glass 200 provided in an embodiment of the present disclosure. The specific structure of the vehicle window glass 200 can refer to FIG. 1 to FIG. 8 and the above description. The improvements to the vehicle window glass 200 can be applied to the above description of the vehicle window glass 200 without conflict. The method includes the following.

S100, inner glass 212 is provided.

S200, a transparent nano coating 220 on a surface of the inner glass is formed. The transparent nano coating 220 includes an enhanced high refractive-index layer 221 and an outermost low refractive-index layer 222. The enhanced high refractive-index layer 221 and the outermost low refractive-index layer 222 are sequentially laminated in a direction away from the inner surface 210a. The refractive index of the enhanced high refractive-index layer 221 is greater than or equal to 2.6. The refractive index of the outermost low refractive-index layer 222 ranges from 1.35 to 1.60.

The refractive index of the enhanced high refractive-index layer 221 may range from 2.60 to 2.72.

S300, the vehicle window glass 200 is formed by laminating outer glass 211, an intermediate layer 213, and the inner glass 212 provided with the transparent nano coating 220.

S100, S200, and S300 will be described as follows.

In a first embodiment, the transparent nano coating 220 has a two-layer structure.

In the first embodiment of the manufacturing method for the vehicle window glass 200, S100, S200, and S300 are specifically described as follows.

S100, inner glass 212 is provided.

Specifically, soda-lime-silica ultra-transparent glass with the thickness of 2.1 mm is used as the inner glass 212. After undergoing cutting, washing, drying, and other vehicle glass treatment processes, the inner glass 212 enters a magnetron sputtering coating line for coating and deposition.

S200, a transparent nano coating 220 is formed on the surface of the inner glass 212. The transparent nano coating 220 includes an enhanced high refractive-index layer 221 and an outermost low refractive-index layer 222. The enhanced high refractive-index layer 221 and the outermost low refractive-index layer 222 are sequentially laminated in the direction away from the inner glass 212. The refractive index of the enhanced high refractive-index layer 221 ranges from 2.60 to 2.72.

Specifically, firstly, a HiPIMS power supply is used as a target power supply, ceramic TiOx is used as a target material, Ar is used as process gas, and a TiOₓ layer is formed on the fourth surface 212b of the inner glass 212 through magnetron sputtering. Secondly, a MF magnetron sputtering power supply is used as a target power supply, SiAl (Si:Al=92:8wt%) is used as a target material, Ar and O₂ are used as process gases, and a SiO₂ layer is formed on a surface of the TiOₓ layer away from the inner glass 212 through magnetron sputtering. Finally, the inner glass having the TiOₓ layer and the SiO₂ layer are subjected to the high-temperature heat treatment of at least 560°C and the bending treatment, such as the baking and bending treatment for vehicle glass, to obtain the transparent nano coating 220.

By using the HiPIMS power supply for magnetron sputtering, the TiOₓ layer has strong adhesion and a high ionization rate. In addition, during the high-temperature heat treatment of at least 560°C and the bending treatment, more TiOₓ materials can be transformed into a rutile structure. Therefore, the refractive index of the enhanced high-refractive index layer 221 in the transparent nano coating 220 can reach 2.60 to 2.72 after the high-temperature heat treatment of at least 560°C and the bending treatment.

S300, the vehicle window glass 200 is formed by laminating the outer glass 211, the intermediate layer 213, and the inner glass 212 provided with the transparent nano coating 220.

Specifically, after the above operations are completed, the outer glass 211 and at least one intermediate layer 213 are prepared. Following the standard production process for laminated safety glass of vehicle, and the aforementioned inner glass 212 and the outer glass 211 are matched. The vehicle window glass 200 with a sandwich structure is manufactured by performing processes such as size pairing and lamination on the inner glass 212 and the outer glass 211.

### A second embodiment

The same parts of the second embodiment of the manufacturing method as those of the first embodiment of the manufacturing method will not be repeated. The second embodiment of the manufacturing method is different from the first embodiment of the manufacturing method as follows. Before magnetron sputtering is performed on the fourth surface 212b of the inner glass 212 to form the enhanced high refractive-index layer 221 in S200, the method may further include the following.

At least one laminated structure 220a is formed on the surface of the inner glass 212. One laminated structure 220a includes a high refractive-index layer and a low refractive-index layer.

In a first possible implementation, the transparent nano coating has a four-layer structure. The transparent nano coating 220 may include a laminated structure 220a, an enhanced high refractive-index layer 221, and an outermost low refractive-index layer 222. The laminated structure 220a includes a first high refractive-index layer 223 and a first low refractive-index layer 224. The manufacturing method for the laminated structure 220a includes operation 1 and operation 2.

Operation 1, the first high refractive-index layer 223 is formed on the fourth surface of the inner glass 212.

Specifically, the MF magnetron sputtering power supply is used as the target power supply, SiAl (Si:Al=92:8wt%) is used as a target material, and the first high refractive-index layer 223 is formed on the fourth surface 212b of the inner glass 212 through magnetron sputtering. The first high refractive-index layer 223 is made of SiOₓN_{y}.

Operation 2, the first low refractive-index layer 224 is formed on the surface of the first high refractive-index layer 223 away from the inner glass 212.

Specifically, the MF magnetron sputtering power supply is used as the target power supply, SiAl (Si:Al=92:8wt%) is used as a target material, and the first low refractive-index layer 224 is formed on the surface of the first high refractive-index layer 223 away from the inner glass 212 through magnetron sputtering. The first low refractive-index layer 224 is made of SiO₂.

After operation 2 is completed, the enhanced high refractive-index layer 221 is formed on the surface of the first low refractive-index layer 224 away from the first high refractive-index layer 223. The outermost low refractive-index layer 222 is formed on the surface of the enhanced high refractive-index layer 221 away from the first low refractive-index layer 224.

The method for forming the enhanced high refractive-index layer 221 and the outermost low refractive-index layer 222 may refer to the description of the first embodiment of the manufacturing method for the vehicle window glass 200. Operation 2 and subsequent operations will not be repeated in this implementation.

In a second possible implementation, the transparent nano coating has a six-layer structure. The transparent nano coating 220 may include two laminated structures 220a. The two laminated structures 220a include a first laminated structure 2201 and a second laminated structure 2202. The first laminated structure 2201 includes a first high refractive-index layer 223 and a first low refractive-index layer 224. The second laminated structure 2202 includes a second high refractive-index layer 225 and a second low refractive-index layer 226.

The manufacturing method for the laminated structure 220a includes operation 1, operation 2, operation 3, and operation 4. The specific methods for operation 1 and operation 2 are the same as those described in the first possible implementation above, and will not be repeated here. In this implementation, the second high refractive-index layer 225 is formed through operation 3, and the second low refractive-index layer 226 is formed through operation 4.

Operation 3, the second high refractive-index layer 225 is formed on the surface of the first low refractive-index layer 224 away from the first high refractive-index layer 223.

Specifically, the MF magnetron sputtering power supply is used as the target power supply, SiAl (Si:Al=92:8wt%) is used as a target material, and the second high refractive-index layer 225 is formed on the surface of the first low refractive-index layer 224 away from the first high refractive-index layer 223 through magnetron sputtering. The second high refractive-index layer 225 is made of SiOₓN_{y}.

Operation 4, the second low refractive-index layer 226 is formed on the surface of the second high refractive-index layer 225 away from the first low refractive-index layer 224.

Specifically, the MF magnetron sputtering power supply is used as the target power supply, SiAl (Si:Al=92:8wt%) is used as a target material, and the second low refractive-index layer 226 is formed on the surface of the second high refractive-index layer 225 away from the first low refractive-index layer 224 through magnetron sputtering. The second low refractive-index layer 226 is made of SiO₂.

After operation 4, the enhanced high refractive-index layer 221 is formed on the surface of the second low refractive-index layer 226 away from the second high refractive-index layer 225. The outermost low refractive-index layer 222 is formed on the surface of the enhanced high refractive-index layer 221 away from the first low refractive-index layer 224.

The method for forming the enhanced high refractive-index layer 221 and the outermost low refractive-index layer 222 may refer to the description of the first embodiment of the manufacturing method for the vehicle window glass 200. Operation 4 and subsequent operations will not be repeated in this implementation.

The TiOₓ layer prepared by using the MF magnetron sputtering power supply as the target power supply has some disadvantages, such as weak adhesion and low ionization rate. After the high-temperature heat treatment of at least 560°C and bending treatment, the TiOₓ layer contains a mixture of rutile-structured TiOₓ and anatase-structured TiOₓ. Since the anatase-structured TiOx is in a metastable phase, the TiOₓ layer has refractive index *n* of 2.50 and extinction coefficient k less than 0.001. In contrast, the TiOₓ layer prepared by the HiPIMS power supply has the strong adhesion and high ionization rate. After the high-temperature heat treatment of at least 560°C and the bending treatment, the TiOₓ layer is mainly composed of rutile-structured TiOₓ, where the proportion of the rutile-structured TiOₓ in the TiOₓ layer is at least 90%, or even 100%. The rutile-structured TiOₓ has high stability, so that the TiOₓ layer has the refractive index *n* ranging from 2.60 to 2.72, and extinction coefficient *k* greater than or equal to 0.0015.

It can be understood that the transparent nano coating 220 of the vehicle window glass 200 at least includes the enhanced high refractive-index layer 221 and the outermost low refractive-index layer 222. The refractive index *n* of the material of the enhanced high refractive-index layer 221 is greater than or equal to 2.60. By using the HiPIMS power supply to deposit the enhanced high refractive-index layer 221, the TiOₓ layer with refractive index n ranging from 2.60 to 2.72 can be obtained after the high-temperature heat treatment at least 560°C and bending treatment. In addition, through reasonable coating system design, the vehicle window glass 200 has both high reflectivity performance for the projection light 21 (the reflectivity of the vehicle window glass 200 for P-polarized light having the wavelength of each of 469 nm, 529 nm, and 629 nm is greater than or equal to 20%) and high transmissivity performance for the detection light 11 (the transmissivity of the vehicle window glass 200 for P-polarized light having the wavelength of each of 905 nm and 1550 nm is greater than or equal to 80%). The vehicle window glass 200 in the present disclosure can integrate both the head-up display function and the detection function into the vehicle window glass 200 by configuring only one transparent nano coating. Therefore, the use of the conventional partition deposition process to disposing different functional coatings is avoided, thereby reducing the process operations, reducing the production difficulty, and improving the production efficiency.

According to the aforementioned embodiments provided in the present disclosure, the reflected color of the vehicle window glass 200 in the present disclosure has a value of *a* less than 3 and a value of *b* less than 0.5 in the color space Lab. Therefore, the vehicle window glass 200 provided in the present disclosure exhibits a beautiful light blue color.

The embodiments of the present disclosure are described in detail above, and specific examples are used herein to expound the principle and implementations of the present disclosure. The description of the above embodiments is only used to help understand the method and core idea of the present disclosure. Meanwhile, for those ordinary skill in the art, there will be changes in the specific implementations and application scope according to the idea of the present disclosure. In summary, the contents of this specification should not be understood as limitations to the present disclosure.

## Claims

1. Vehicle window glass, comprising a glass substrate and a transparent nano coating, wherein the glass substrate has an outer surface and an inner surface opposite to the outer surface, the transparent nano coating is disposed on the inner surface, the transparent nano coating comprises an enhanced high refractive-index layer and an outermost low refractive-index layer, and the enhanced high refractive-index layer and the outermost low refractive-index layer are sequentially laminated in a direction away from the inner surface; and
the enhanced high refractive-index layer has a refractive index greater than or equal to 2.6, and the outermost low refractive-index layer has a refractive index ranging from 1.35 to 1.60.

2. The vehicle window glass of claim 1, wherein the vehicle window glass has a transmittance greater than or equal to 80% for P-polarized light having a wavelength ranging from 850 nm to 1650 nm incident at an incident angle ranging from 50° to 73°.

3. The vehicle window glass of claim 1, wherein the vehicle window glass has a reflectivity greater than or equal to 20% for P-polarized light having a wavelength of 380 nm to 780 nm incident from an inside of a vehicle at an incident angle ranging from 45° to 85°.

4. The vehicle window glass of any one of claims 1 to 3, wherein the enhanced high refractive-index layer has a thickness ranging from 35 nm to 70 nm.

5. The vehicle window glass of any one of claims 1 to 3, wherein the outermost low refractive-index layer has a thickness ranging from 75 nm to 130 nm.

6. The vehicle window glass of any one of claims 1 to 3, wherein the enhanced high refractive-index layer is a TiOₓ layer, and a proportion of rutile-structured TiOₓ in the TiOₓ layer is at least 90%.

7. The vehicle window glass of claim 6, wherein the TiOₓ layer has a refractive index n ranging from 2.60 to 2.72, and has an extinction coefficient k greater than or equal to 0.0015.

8. The vehicle window glass of any one of claims 1 to 3, wherein the glass substrate comprises outer glass, inner glass, and an intermediate layer disposed between the outer glass and the inner glass, a surface of the outer glass away from the intermediate layer is the outer surface, a surface of the inner glass away from the intermediate layer is the inner surface, and the outer glass and/or the inner glass has a transmittance greater than or equal to 91% for near-infrared light having a wavelength ranging from 850 nm to 1650 nm.

9. The vehicle window glass of claim 8, wherein the transparent nano coating is composed of the enhanced high refractive-index layer and the outermost low refractive-index layer, the enhanced high refractive-index layer has a thickness ranging from 45 nm to 65 nm, and the outermost low refractive-index layer has a thickness ranging from 90 nm to 120 nm.

10. The vehicle window glass of claim 8, wherein the transparent nano coating further comprises at least one laminated structure, at least one laminated structure is disposed between the enhanced high refractive-index layer and the inner glass, each of the at least one laminated structure comprises a high refractive-index layer and a low refractive-index layer that are sequentially laminated, the high refractive-index layer has a refractive index ranging from 1.61 to 2.59, and the low refractive-index layer has a refractive index ranging from 1.35 to 1.60.

11. The vehicle window glass of claim 10, wherein the at least one laminated structure is implemented as one laminated structure, the high refractive-index layer is disposed on a surface of the inner glass away from the intermediate layer, the low refractive-index layer is disposed between the high refractive-index layer and the enhanced high refractive-index layer, the high refractive-index layer has a thickness ranging from 2 nm to 190 nm, the low refractive-index layer has a thickness ranging from 5 nm to 95 nm, the enhanced high refractive-index layer has a thickness ranging from 45 nm to 65 nm, and the outermost low refractive-index layer has a thickness ranging from 85 nm to 130 nm.

12. The vehicle window glass of claim 10, wherein the at least one laminated structure is implemented as two laminated structures, the two laminated structures comprise a first laminated structure and a second laminated structure, the first laminated structure comprises a first high refractive-index layer and a first low refractive-index layer, and the second laminated structure comprises a second high refractive-index layer and a second low refractive-index layer; the first high refractive-index layer, the first low refractive-index layer, the second high refractive-index layer, the second low refractive-index layer, the enhanced high refractive-index layer, and the outermost low refractive-index layer are sequentially laminated on the surface of the inner glass away from the intermediate layer; and the first high refractive-index layer has a thickness ranging from 140 nm to 190 nm, the first low refractive-index layer has a thickness ranging from 5 nm to 95 nm, the second high refractive-index layer has a thickness ranging from 130 nm to 205 nm, the second low refractive-index layer has a thickness ranging from 25 nm to 90 nm, the enhanced high refractive-index layer has a thickness ranging from 45 nm to 65 nm, and the outermost low refractive-index layer has a thickness ranging from 75 nm to 105 nm.

13. The vehicle window glass of claim 8, wherein the intermediate layer has a wedge angle equal to 0, or ranging from 0.01 mrad to 0.15 mrad.

14. The vehicle window glass of claim 8, wherein the intermediate layer is a tinted intermediate layer having a visible light transmittance greater than or equal to 80%.

15. The vehicle window glass of any one of claims 1 to 3, wherein the vehicle window glass has a visible light transmittance greater than or equal to 70%, and a reflected color of the vehicle window glass measured from the outer surface has a value of *a* less than 3 and a value of *b less* than 0.5 in a color space Lab.

16. The vehicle window glass of any one of claims 1 to 3, wherein a range of reflectivities of the vehicle window glass for P-polarized light having wavelengths of 469 nm, 529 nm, and 629 nm, incident from an inside of a vehicle at an incident angle of 65°, is less than or equal to 3%.

17. A vehicle, comprising a detection assembly, a projection assembly, and the vehicle window glass of any one of claims 1 to 16, wherein the detection assembly and the projection assembly are disposed at one side of the vehicle window glass where the transparent nano coating is disposed, the vehicle window glass has a signal transmission region and/or a head-up display region, the detection assembly is configured to emit and/or receive detection light having a wavelength ranging from 850 nm to 1650 nm, the detection light is configured to pass through the vehicle window glass, and the projection assembly is configured to emit projection light having a wavelength ranging from 380 nm to 780 nm towards the head-up display region;
the detection light is incident onto the signal transmission region at an incident angle ranging from 50° to 73°, and at least 80% of the detection light is P-polarized light; and
the projection light is incident onto the head-up display region at an incident angle ranging from 45° to 85°, and at least 90% of the projection light is P-polarized light.

18. A manufacturing method for vehicle window glass, comprising:
providing inner glass;
forming a transparent nano coating on a surface of the inner glass, wherein the transparent nano coating comprises an enhanced high refractive-index layer and an outermost low refractive-index layer, the enhanced high refractive-index layer and the outermost low refractive-index layer are sequentially laminated in a direction away from the inner glass, the enhanced high refractive-index layer has a refractive index greater than or equal to 2.6, and the outermost low refractive-index layer has a refractive index ranging from 1.35 to 1.60; and
forming the vehicle window glass by laminating outer glass, an intermediate layer, and the inner glass provided with the transparent nano coating.

19. The manufacturing method of claim 18, wherein forming the transparent nano coating on the surface of the inner glass comprises:
forming the enhanced high refractive-index layer by magnetron sputtering, wherein a target power supply for magnetron sputtering of the enhanced high refractive-index layer is a high-power impulse magnetron sputtering (HiPIMS) power supply; and
forming the outermost low refractive-index layer on a surface of the enhanced high refractive-index layer away from the inner glass by magnetron sputtering, wherein a target power supply for magnetron sputtering of the outermost low refractive-index layer is a mid-range frequency (MF) magnetron sputtering power supply.

20. The manufacturing method of claim 18, wherein the transparent nano coating further comprises at least one laminated structure, the at least one laminated structure is disposed between the enhanced high refractive-index layer and the inner glass, each of the at least one laminated structure comprises a high refractive-index layer and a low refractive-index layer that are sequentially laminated, the high refractive-index layer has a refractive index ranging from 1.61 to 2.59, and the low refractive-index layer has a refractive index ranging from 1.35 to 1.60; and
the high refractive-index layer and the low refractive-index layer are formed by magnetron sputtering, and a target power supply for magnetron sputtering of the high refractive-index layer and the low refractive-index layer is a MF magnetron sputtering power supply.
